Europäisches Patentamt

European Patent Office

Office européen des brevets

(11) Publication number: **0 469 589 A2**

# EUROPEAN PATENT APPLICATION

(21) Application number: **91112894.0**

(22) Date of filing: **31.07.91**

(51) Int. Cl.⁵: **G11C 5/14**

(30) Priority: **31.07.90 US 560646**

(43) Date of publication of application:
**05.02.92 Bulletin 92/06**

(84) Designated Contracting States:
**DE FR GB IT NL**

(71) Applicant: **TEXAS INSTRUMENTS INCORPORATED**
**13500 North Central Expressway**
**Dallas Texas 75265(US)**

(72) Inventor: **Hellums, James R.**
**5200 Meadow Creek Dr., Apt. No. 1005**
**Dallas, Texas 75248(US)**
Inventor: **Krenik, William R.**
**5909 Indian Hills Dr.**
**Garland, Texas 75044(US)**
Inventor: **Iyengar, Narasimhan**
**4425 Early Morn**
**Plano, Texas 75093(US)**

(74) Representative: **Leiser, Gottfried, Dipl.-Ing. et al**
**Patentanwälte Prinz, Leiser, Bunke & Partner**
**Manzingerweg 7**
**W-8000 München 60(DE)**

(54) Improvements in or relating to integrated circuits.

(57) A circuit for regulating the voltage to a memory is disclosed. the circuit has a driver transistor connected between an external voltage supply and the memory and has a comparator having an input connected to a reference generator and an input coupled to the memory array, to control the gate of the driver transistor. A method of regulating the voltage to a memory array in a semiconductor memory device having an on chip voltage generator is also disclosed. The method includes the steps of coupling the memory array to an external voltage supply through a driver transistor, generating a reference voltage, and comparing the reference voltage to the voltage of the memory array. The driver transistor is controlled with the results of the comparison.

Fig.10

This invention relates to integrated circuits, and in particular to integrated circuit devices formed in a semiconductor substrate, for example memory devices such as dynamic random access memories.

The development of very large scale integrated circuit (VLSI) semiconductor devices of the Dynamic Random Access Memory (DRAM) type is well known. Over the years, the industry has steadily progressed from DRAMS of the 16K type (as shown in the U.S. Pat. 4,055,444 issued to Rao) to DRAMS of the 1MB type (as shown in U.S. Pat. 4,658,377 issued to McElroy), and progressed to DRAMS of the 4MB type. A 16MB DRAM, wherein more than 16 million memory cells and associated circuitry are integrated on a single memory chip, is the next generation of DRAM scheduled for production.

Presently in designing VLSI semiconductor memory devices of the 16MB DRAM type, designers are faced with numerous challenges.

One cause for concern, for example, is power consumption, including the power consumed by an chip circuits, which regulate external supplies to supply internal circuits, such as the memory array and array peripheral circuits. The problem is exacerbated if significant circuit blocks are to be supplied with internally regulated voltages that differ from the nominal device supply voltage.

According to the present invention in one aspect thereof;

a method of regulating the voltage supplied to a node in a semiconductor device having an on chip voltage generator, comprises the steps of:

coupling the node to an external voltage supply through a driver transistor to charge the node with external voltage;

generating a reference voltage;

comparing the reference voltage to the voltage on the node; and

regulating the driver transistor with the results of the comparing step.

Preferably, the node is connected to a memory array of a semiconductor memory device. Alternatively, the node is connected to periphery circuits of a semiconductor memory device.

According to the present invention in a further aspect thereof, there is provided a circuit, integrated with said semiconductor device, for performing the aforementioned method.

Preferably, a circuit for regulating voltage in a semiconductor memory device having an on chip voltage reference generator comprises:

a driver transistor connected to an external voltage supply and to the memory; and

a comparator having an input connected to the output of the on chip reference generator and an input coupled to an external voltage supply, the output of the comparator being connected to the driver transistor, to compare the external voltage supply and the output of the reference generator and thereby control voltage supplied to the device memory array through the driver transistor.

Preferably, also a circuit to drive the periphery of a semiconductor memory device having an on chip voltage reference generator to generate an internal reference voltage, comprises:

a pass transistor to charge the periphery from an external voltage supply; and

a comparator, coupled to the pass transistor, whose trip point is set by the output of the voltage reference generator and the charge supplied to the periphery, to control the pass transistor.

In a preferred form of the present invention, a circuit for a memory device integrated onto a single semiconductor substrate, comprises:

a memory array;

support circuitry for reading information from the memory array and writing information to the memory array;

a voltage generator to receive external voltage and generate internal reference voltage to power the memory array and support circuitry; and

a circuit connected coupled to the memory array, to the external voltage, and to the internal reference voltage, supply to charge the memory array from the external voltage supply and to use the internal reference voltage to regulate the amount of supplied charge.

Preferably, the circuit includes:

a transistor having one terminal connected to the external voltage, another terminal connected to ground, and having a gate, to drive the memory array; and

a comparator having one comparison input connected to the internal voltage, the other comparison input coupled to the external voltage, and the output connected to the gate of the transistor, to compare the external voltage and the internal voltage and bias the gate of the transistor with the results of the comparison.

As part of this application on exemplary control circuit for regulating the voltage to a memory is disclosed. The circuit has a driver transistor connected between an external voltage supply and the memory and has a comparator having an input connected to a reference generator and an input coupled to the memory array, to control the gate of the driver transistor. A method of regulating the voltage to a memory array in a semiconductor memory device having an on chip voltage generator is also disclosed. The method includes the steps of coupling the memory array to an external voltage supply through a driver transistor, generating a reference voltage, and comparing the reference voltage to the voltage of the memory array.

The driver transistor is controlled with the results of the comparison.

Other objects, advantages and features of the invention will become apparent to those of ordinary skill in the art, having reference to the following description of embodiments of the invention which together with the accompanying drawings are provided by way only of example.

In the drawings:-

FIG. 1 is a block system level drawing illustrating a 16MB Dynamic Random Access Memory chip incorporating an embodiment of the invention,

FIG. 2 is a top view drawing illustrating the pin designations of the packaged memory chip,

FIG. 3 is a three-dimensional view of the packaged memory chip wherein the encapsulating material is rendered transparent,

FIG. 4 is an assembly view if FIG. 3,

FIG. 5 is a cross-sectional view of FIG. 3,

FIG. 6 is a top view drawing illustrating the bond pad designations of the memory chip,

FIG. 7 is a top view drawing illustrating a portion of the memory array,

FIG. 8 is a cross-sectional view of a portion of the memory array,

FIG. 9 is a side view of the cross-sectional view of FIG. 8,

FIG. 10 illustrates the VPERBUF circuit,

FIG. 11 illustrates the VARYDRV circuit,

FIG. 12 illustrates the VPERDRV circuit.

FIG. 13 illustrates the VARYDRVS circuit, and

FIG. 14 illustrates the VPERDRVS circuit.

An exemplary embodiment of the invention and a memory chip including the invention will now be described.

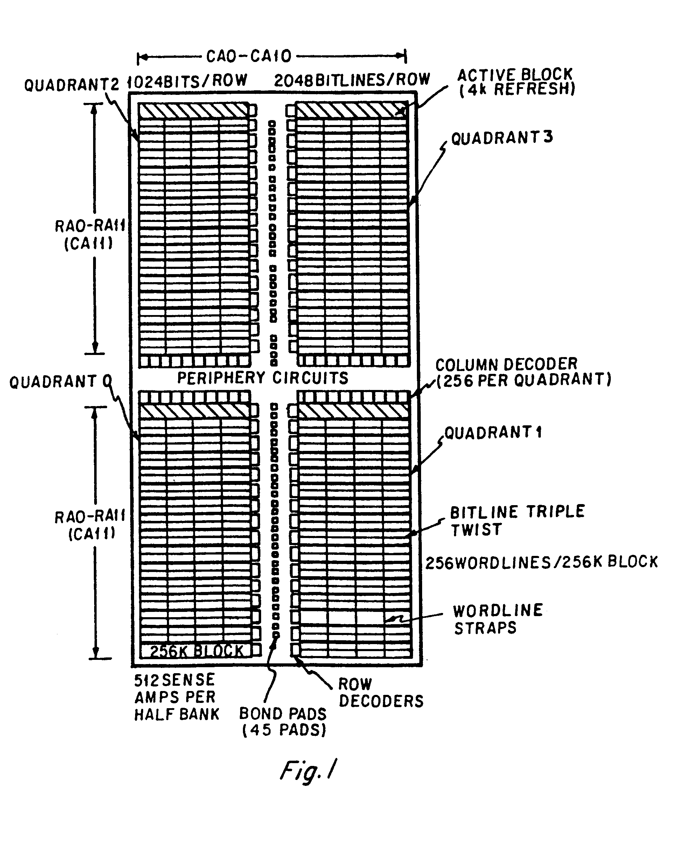

Fig. 1 illustrates a 16MB Dynamic Random Access Memory Chip referred to as a 16MB DRAM. The chip size is about 325 x 660 mm. The chip is partitioned into four memory array quadrants. Each memory array quadrant contains 4 Megabits. A 4MB memory array quadrant contains 16 memory blocks. Each memory block contains 256 Kilobits. The Column Decoders lie along the vertical axis of the chip adjacent to their respective memory array quadrants. The ROW decoders lie along the horizontal axis of the chip, adjacent to their respective memory array quadrants. The periphery circuits containing such devices as the input and output buffers and the timing and control circuits are centrally located along both the horizontal and the vertical axis of the chip. The bond pads are centrally located along the horizontal axis of the chip.

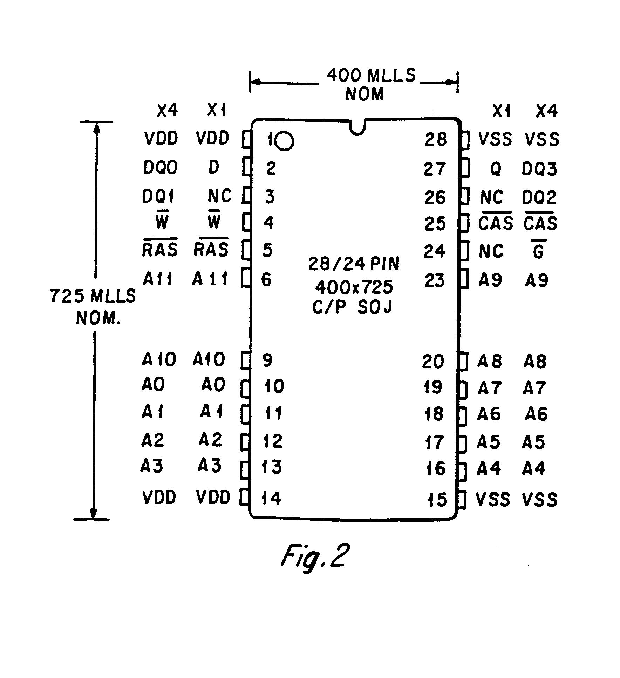

FIG. 2 is a top view drawing illustrating the package/pin out of the device. The chip is center bonded and encapsulated in a thin plastic, small outline J-type package. Among other features, the DRAM is bond programmable as either an X1 or an X4 device. The pin designations for both the X1 and X4 modes of operation are illustrated.

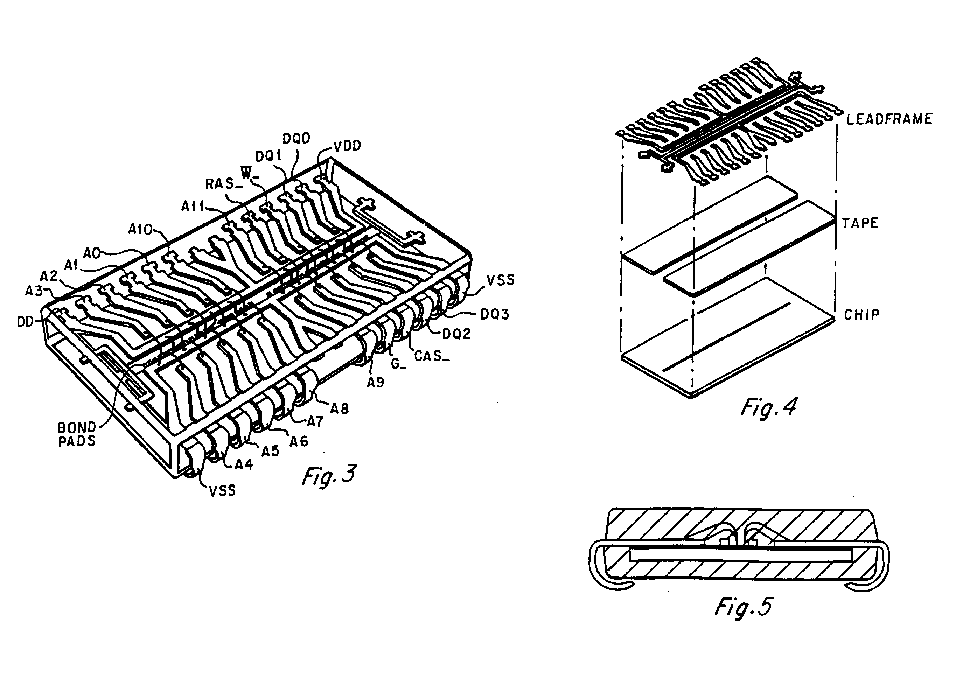

FIG. 3 is a three-dimensional view of the encapsulated chip wherein the encapsulating plastic is rendered transparent. The pin designations shown correspond to the X4 option. The TSOJ package is of the lead over chip with center bond (LOCCB) type. Basically, the chip lies underneath the lead fingers. A polyamide tape attaches the chip to the lead fingers. Gold wires are wire-bonded from the lead fingers to the center bonding pads of the chip.

FIG. 4 is an assembly view of the packaging concept and

FIG. 5 is a cross-section view of the packaged device.

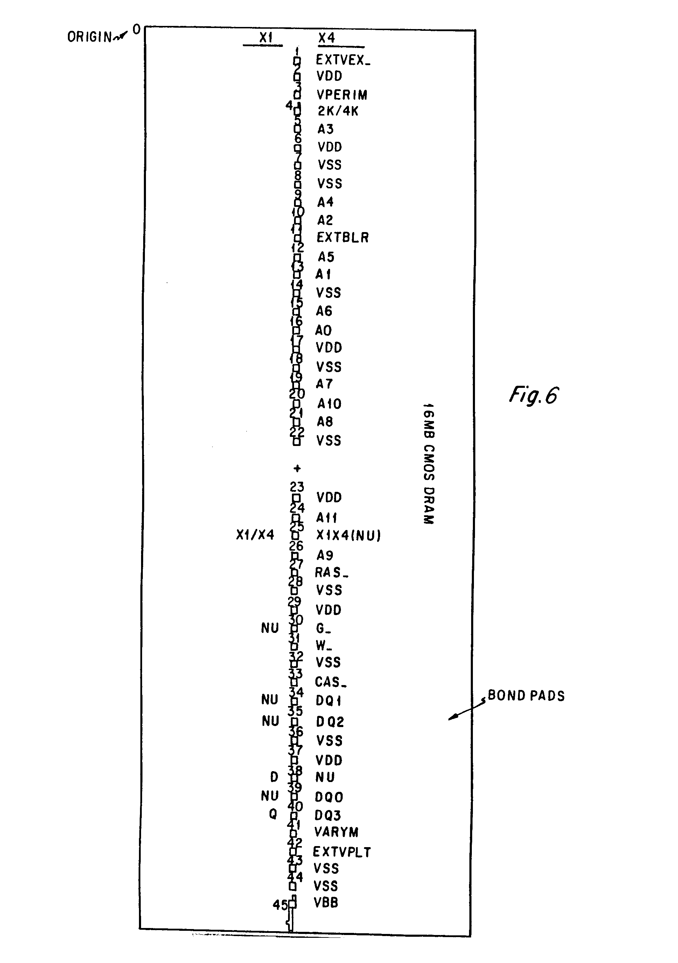

FIG. 6 is a diagram illustrating the names and sequence of the bond pads. The sequence for both the X1 and the X4 options are illustrated. EXT BLR is a pad that is for in-house only. The brackets, such as those for bond pad 4 and 25 indicate that this is a bond pad option.

General characteristics of the 16MB DRAM device of FIG. 1 follow. The device receives external VDD of typically 5 volts. On chip internal voltage regulation powers the memory arrays at 3.3 volts and the periphery circuits at 4.0 volts to reduce power consumption and channel hot carrier effects. The substrate is biased at -2 volts. The organization is bond programmable X1/X4. The X1 or X4 option may be selected during manufacture by putting in place a bond wire between bond pad 25 (FIG. 6) and $V_{SS}$ for a X1 device and omitting the bond wire for a X4 device. The resulting pin outs for the ten options may be seen in FIG. 2. The bond wire may be run between pad 25 and the $V_{SS}$ bus 3 of the lead frame (FIG. 3).

The enhanced page mode is the preferred option, with a metal mask programmable option for a write per bit (data mask) operation.

The preferred option for the refresh scheme is 4096 cycles at 64ms. However, the DRAM is bond programmable for 2048 cycle refresh. Option selection may be achieved in a way analogous to that employed for the X1 or X4 option selection. The relevant bond pad is 4, bonded to $V_{SS}$ for 2K refresh, otherwise the 4K refresh option is exercised.

The DRAM has numerous design-for-test features. Test mode entry 1 is through WCBR with no address key for 16X internal parallel test with mode data compare. Test mode entry 2 is WCBR with over-voltage and address key only thereafter (8 volts on A11). Exit from test mode occurs from any refresh cycle (CBR or RAS only). Test mode entry 1 is the industry standard 16X parallel test. This test is similar to those used on the 1MB and 4MB

DRAMS, except that 16 bits are compared simultaneously instead of 8 bits. The valid address keys are A0, A1, A2, and A6. Test mode entry 2 contains numerous tests. There is a 32X parallel test with data compare and a 16X parallel test with data compare. Different hexadecimal addresses are keyed for the different parallel tests. A storage cell stress test and a VDD margin test allows connection of the external VDD to internal VARY and VPERI device supply lines through the P-channel devices. Other tests include a redundancy signature test, a row redundancy roll call test, a column redundancy roll call test, a row transfer test, a word-line leakage detection test, clear concurrent test modes, and a reset to normal mode. The DRAM also contains a test validation method that indicates if it has remained in a test mode.

Although not illustrated in FIG. 1, for clarity, the DRAM contains redundancy features for defect elimination. It has four redundant rows per 256K memory block. All four may be used at one time. There are 3 decoders per redundant row and 11 row addresses per redundant row decoder. It uses fuses for row redundancy with, on-average, 10 fuses blown for a single repair. The row redundancy uses a two stage programmable concept to more efficiently to enable repair. There are 12 redundant columns per quadrant and four decoders per redundant column. There are 8 column addresses and 3 row addresses per decoder. The total fuse count for column repair is about, on average, 10 fuses blown for a single repair. Column redundancy also has a two-stage programmable feature to more efficiently enable repair.

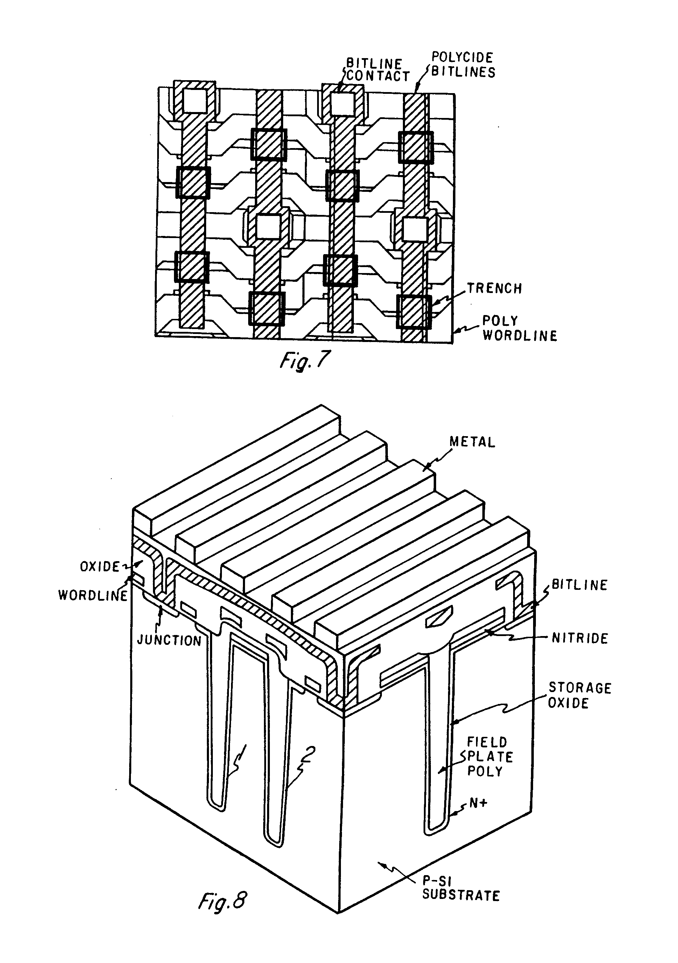

FIG. 7 is a top view of the capacitor cell layout. The bit lines are poly-3 ($TiSi_2$) polyside. No bitline reference is used and the bitlines are triple twisted for noise immunity. The supply line voltage is about 3.3 volts. The word lines are segmented poly-2. They are strapped every 64 bits with metal 2. The memory cells are of the modified trench capacitor type and may be formed by a process such as disclosed in United States Patent 5,017,506 and European Patent Application 0410288.

Alternative suitable memory cells of the stacked trench-type are disclosed in United States Patent 4,978,634.

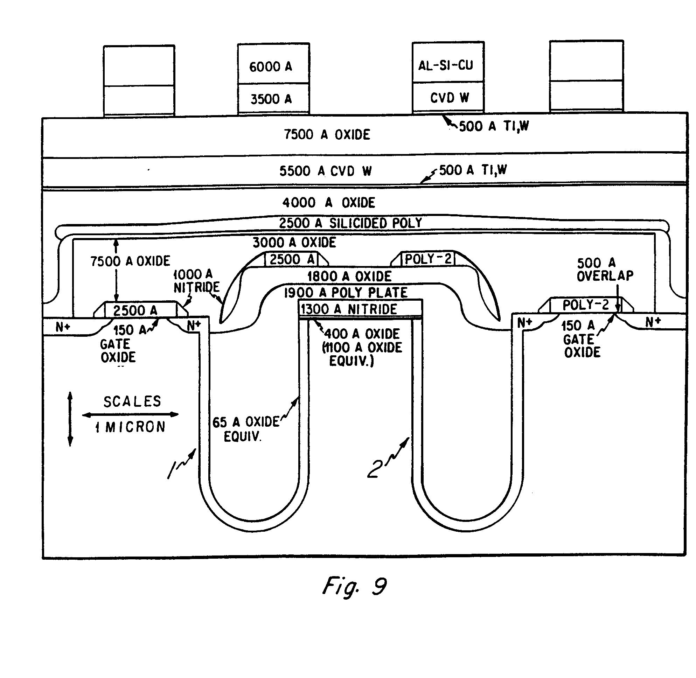

In FIG. 7, the dimensions include a 1.6um bitline pitch by 3.0um double word line pitch, with a cell size of about $4.8um^2$ obtained through 0.6 micron technology. The trench opening is about 1.1um and the trench depth is about 6.0um. The dielectric is of nitride/oxide, having a thickness of about 65A. Field plate isolation is utilized. The transistors have thin gate oxide. FIG. 8 is a cross-sectional view of the modified trench capacitor cell and FIG. 9 is a side view of the trench capacitor cell.

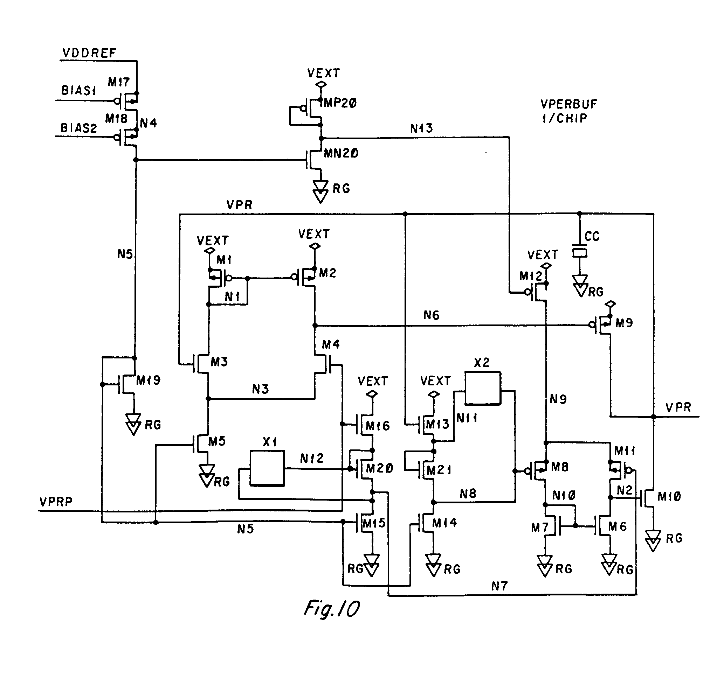

In FIG. 10, P-channel transistor M9 and N-channel transistor M10 are connected in series and respectively biased between VDD and VSSRG. The gate of P-channel transistor M9 is connected to the series connection between P-channel transistor M2 and N-channel transistor M4. The gate of N-channel transistor M10 is connected to the series connection between P-channel transistor M11 and N-channel transistor M6. The series connection between transistors M9 and M10 is connected to the output VPR. Capacitor CC has one terminal connected to the gate of N-channel transistor M3 (connected to VPR) and the other connected to VSSRG. The substrate terminals of P-channel transistors M8 and M11 are connected to node N9.

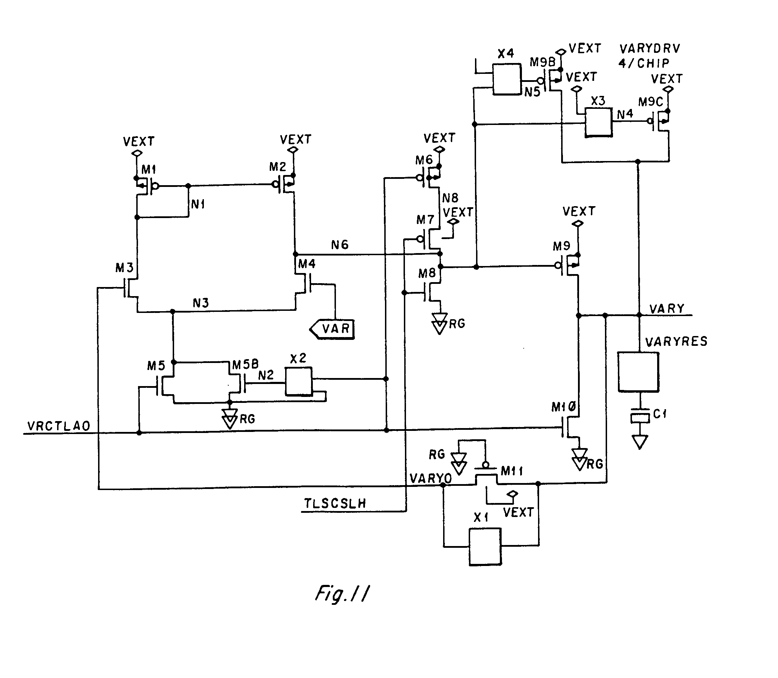

FIG. 11 illustrates the Voltage Array Driver circuit, VARYDRV. P-channel transistor M1 and N-channel transistor M3 are connected in series respectively between VDD and Node N3. P-channel transistor M2 and N-channel transistor M4 are connected in series respectively between VDD and Node N3. The gates of P-channel transistors M1 and M2 are connected together and are connected to the series connection between M1 and M3. The gate of M3 is connected to Node VARYo. The gate of M4 is connected to VAR. N-channel transistors M5 and M5B are connected in parallel between Node N3 and VSSRG. The gate M5 is connected to VRCTLAO. The gate of M5B is connected to the common terminal of SWITCH X2. The A terminal of SWITCH X2 is connected to VSSRG. The B terminal of SWITCH X2 is connected to VRCTLAO.

In the Voltage Array Driver circuit of FIG. 11, P-channel transistor M6, P-channel transistor M7, and N-channel transistor M8 are connected in series respectively between VDD and VSSRG. The gate of transistor M6 is connected to VRCTLAO. The gate of M7 and M8 are connected together and connected to TLSCSLH. The series connection between M2 and M4 at Node N6.

In FIG. 11, VDD is connected to the B terminal of SWITCH X4. The A terminal of SWITCH X4 is connected to Node N6. The common terminal of SWITCH X4 is connected to the gate of P-channel transistor M9b. Transistor M9B is connected between VDD and the output VARY. The B terminal of SWITCH X3 is connected to VDD. The A terminal of SWITCH X3 is connected to Node N6. The common terminal of SWITCH X3 is connected to the gate of P-channel transistor M9C. Transistor M9C is connected between VDD and the output VARY. P-channel transistor M9 and N-channel transistor M10 are connected in series respectively between VDD and VSSRG. The gate of transistor M9 is connected to Node N6. The gate of N-channel transistor M10 is connected to VRCTLAO. The series connection between M9 and M10 is connected to the output VARY.

In the Voltage Array Driver circuit, VARYDRV of FIG. 84, P-channel transistor M11 couples the output VARY to Node VARYO. The gate of P-channel transistor M11 is connected to VSSRG. SWITCH X1 is connected to the source and drain of transistor M11. One terminal of the resistor VARYRES is connected to the output VARY. The other terminal of resistor VARYRES is connected to one terminal of capacitor C1. The other terminal of capacitor C1 is connected to VSS. All P-channel substrate connections are ties to VDD, in FIG. 84.

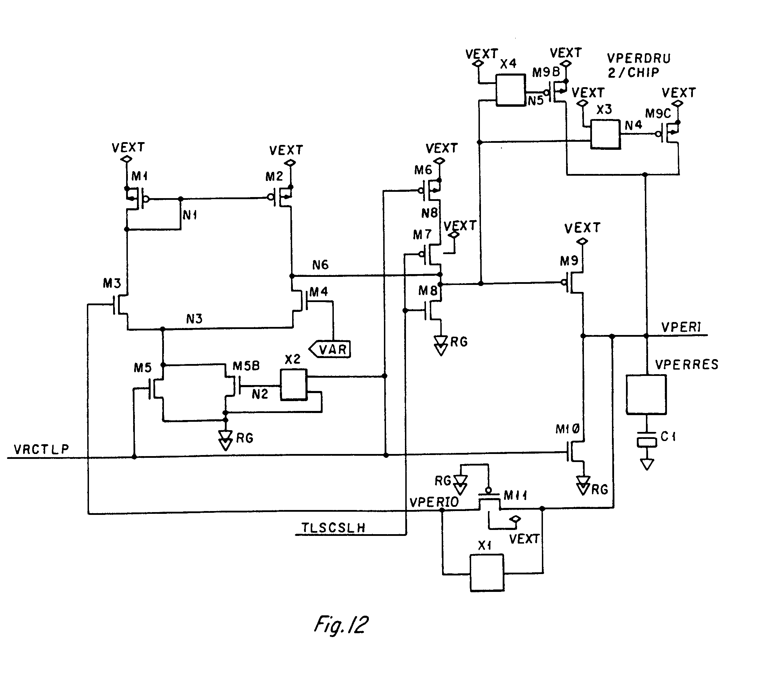

FIG. 12 illustrates the Voltage Periphery Driver circuit, VPERDRV. P-channel transistor M1 and N-channel transistor M3 are connected in series respectively between VDD and Node N3. P-channel transistor M2 and N-channel transistor M4 are connected in series respectively between VDD and Node N3. The gates of P-channel transistors M1 and M2 are connected together and are connected to the series connection between M1 and M3. The gate of M3 is connected to Node VPERI0. The gate of M4 is connected to VPR. N-channel transistors M5 and M5B are connected in parallel between Node N3 and VSSRG. the gate of M5 is connected to VRCTLP. The gate of M5B is connected to the common terminal of SWITCH X2. The terminal of SWITCH X2 is connected to VSSRG. The B terminal of SWITCH X2 is connected to VRCTLP.

In the Voltage Periphery Driver circuit of FIG. 85, P-channel transistors M6, P-channel transistor M7, and N-channel transistor M8 are connected in series respectively between VDD and VSSRG. The gate of transistor M6 is connected to VRCTLP. The gates of M7 and M8 are connected together and connected to TLSCSLH. The series connection between M7 and M8 is connected to the series connection between M2 and M4 and Node N6.

In FIG. 12, VDD is connected to the B terminal of SWITCH X4. The A terminal of SWITCH X4 is connected to Node N6. The common terminal of SWITCH X4 is connected to the gate of P-channel transistor M9B. Transistor M9B is connected between VDD and the output VPERI. The B terminal of SWITCH X3 is connected to Node N6. The common terminal of SWITCH X3 is connected to the gate of P-channel transistor M9C. Transistor M9C is connected between external VDD and the output VPERI. P-channel transistor M9 and N-channel transistor M10 are connected in series respectively between VDD and VSSRG. The gate of transistor M9 is connected to Node N6. The gate of N-channel transistor M10 is connected to VRCTLP. The series connection between M9 and M10 is connected to output VPERI.

In the Voltage Array Periphery circuit, VPERDRV of FIG. 12, P-channel transistor M11 couples the output of VPERI to Node VPERI0. The gate of P-channel transistor M11 is connected to VSSRG. SWITCH X1 is connected to the source and drain of transistor M11. One terminal of the resistor VPERRES is connected to the output VPERI. The other terminal of capacitor C1. The other terminal of capacitor C1 is connected to VSS. All the P-channel substrate connections in FIG. 85 are tied to VDD.

    VARYDRV    - VOLTAGE ARRAY DRIVER
    VPERDRV    - VOLTAGE PERIPHERY DRIVER
                     - schematic FIG. 11 and 12

These are the main drivers for the device. There are 4 VARYDRVs. They provide the array voltage of 3.3V to the array sense amplifiers. Two of them support quadrants Q0 and Q1, and the other 2 support Q2 and Q3. Each of these drivers drive supplies to either the left or right octant of two quadrants. As for, VPERDRV, there are two of them. They are for the various periphery circuits.

These drivers are constructed with CMOS differential amplifier with class A stage driver. The circuit is connected as a comparator and unity gain buffer, with feedback from its output to its input terminal.

A variation of this circuit from the conventional circuit is that instead of using M5 and M10 merely as current source at the source couple pair and the output stage, they serve as control to enable or disable the drivers. The signal that is used to do this control is VRCTLAO for VARYDRV and VRCTLP for VPERDRV. Thus, with this control, only the necessary drivers are activated. Note that, if the drivers are left active, continuous current will flow to GND due to the class A output stage, which would increase standby current.

Under DFT, STORAGE CELL STRESS mode, active TLSCLSH signal isolates the first stage of the comparator, source couple pair, from its second stage, output stage. At the same time, it fully switches on M9, thus forcing the driver output, VARY or VPERI to be the external voltage.

During the comparator analysis, the metal level, CUT POINT can be cut. by doing so, it opens the feedback loop for AC signals. Thus allowing open loop analysis of the AC characteristic (bandwidth and gain) of the comparator.

R1 and C1 serve as damper for the output, VARY or VPERI.

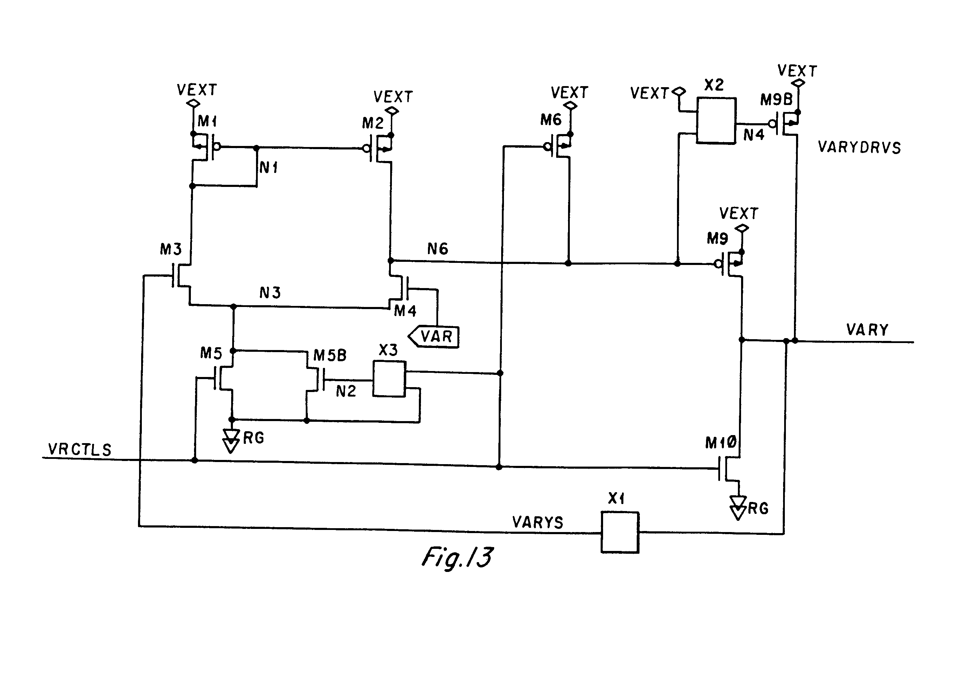

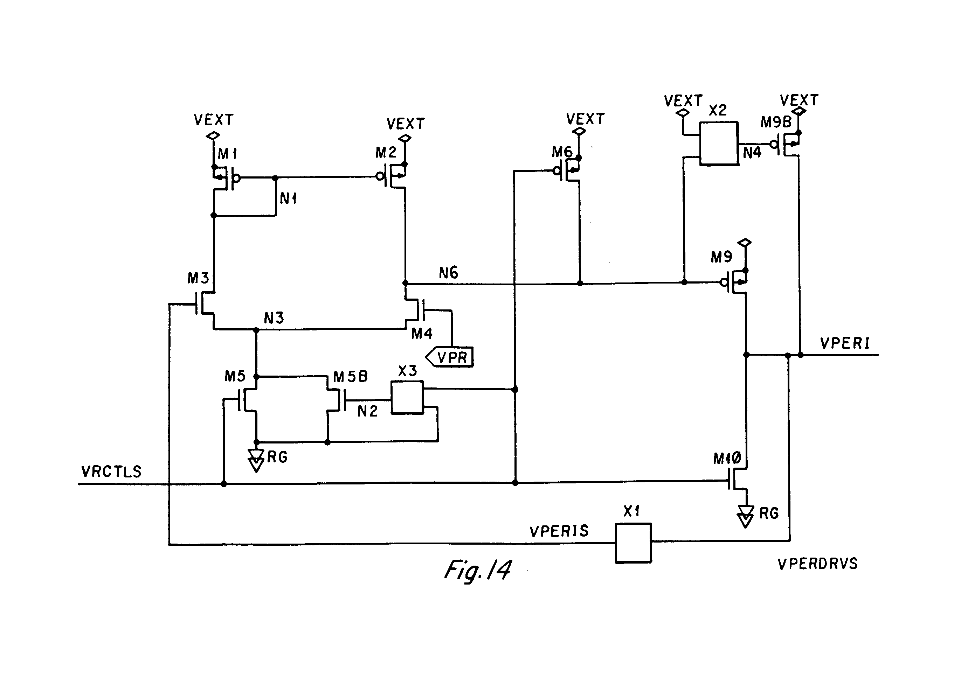

    VARYDRVS    - VOLTAGE ARRAY DRIVER STANDBY
    VPERDRVS    - VOLTAGE PERIPHERY DRIVER STANDBY
                     - schematic FIG. 13 and 14

These circuits are the same as the main drivers except for the smaller transistor sizing and all the control is done at the current source transistors M5 and M10. It does not have an independent circuit for DFT, TLSCSLH signal to control the output stage. This DFT control is incorporated into the M5 and M10 switching. In this DFT mode, (Storage Cell Stress), the drivers are disabled. Hence, only the main drivers are used to supply the external voltage to the device.

As in the main drivers, the feedback loop can be cut. This allows both open loop gain and open loop bandwidth to be determined.

There is one of each of these circuits on the device. They are used to supply leakage current to the device.

An important feature of the arrangement described is that the potentially large power consumption of a regulator placed intermediate a reference source and the memory array of a memory device is avoided. Instead, the array is supplied by the external voltage VDD(E) directly and the supply node of the array allowed to change towards the supply voltage. A comparator sensing both the array supply voltage and a reference voltage is tied to ensure that the charging of the bond ceases before the full supply voltage is reached. Should the voltage drop, the comparator reactivates the charging.

Referring to FIG. 11, a control signal VRCTLAO switches on a transistor MS to enable a comparator formed of M1, M2, M3 and M4. A load in the form of a memory array is represented by VARYRES and C1. VARY is used to designate the array supply. VAR is a reference voltage provided from the circuit of FIG. 10 and derived from VDD(E).

Considering a power up sequence VARY will initially be zero. At some point during power up, signal VRCTLAO enables the comparator. Since VAR (applied to M3) must exceed VARY (applied to M4), M3 is off and M4 is on. M4 also turns on M9 which connects VEXT(E) to VARY. The array supply voltage will thus charge toward VEXT. When VARY approaches VAR, the comparator will change state with M3 and M4 off. Thus, M9 is turned off. When the array supply begins to drop, the comparator will retrigger again to boost the array supply voltage via M9. It will be noted the VAR is used to set the trigger point of a comparator and this does not require the low impedance or high current drive capabilities of the regulated array supply.

The circuit described is particularly although not exclusively suitable for a memory array. Firstly, an array is an eventually capacitive load which itself helps to stabilize the voltage and maintain the charge. Further, stable supply may not be required all the time, for example, when the supply is inactive or not being accessed. Indeed, timing control may be applied via VRCTLAO and/or TLSCSCH to charge the array prior to access such that, the supply voltage is stable during access. Hence, in this variation, M9 is not energized during array access. Instead of retriggering the capacitor as the supply drops, similar smaller topping up circuits may be utilized, particularly when the device is active. Such a circuit is shown in FIGS. 13 and 14. FIG. 12 shows the circuit VPERDRV, which driver circuit peripheral to the array, such as decoders and sense amplifiers. It is similar to the circuit described above, but utilized different control signals and a different reference voltage.

## Claims

1. A method of regulating the voltage supplied to a node in a semiconductor device having an on chip voltage generator, comprising the steps of:

   coupling the node to an external voltage supply through a driver transistor to charge the node with external voltage;

   generating a reference voltage;

   comparing the reference voltage to the voltage on the node; and

   regulating the driver transistor with the results of the comparing step.

2. The method of claim 1 wherein the node is connected to a memory array of a semiconductor memory device.

3. The method of claim 1 wherein the node is connected to periphery circuits of a semiconductor memory device.

4. A circuit, integrated with said semiconductor device, for performing the method as claimed in any preceding claim.

5. A circuit as claimed in claim 4 for regulating voltage in a semiconductor memory device having an on chip voltage reference generator comprising:

   a driver transistor connected to an external voltage supply and to the memory; and

   a comparator having an input connected to the output of the on chip reference generator and an input coupled to an external voltage supply, the output of the comparator being connected to the driver transistor, to compare the external voltage supply and the output of the reference generator and thereby control voltage supplied to the device memory array through the driver transistor.

6.  A circuit as claimed in claim 4 to drive the periphery of a semiconductor memory device having an on chip voltage reference generator to generate an internal reference voltage, comprising:

    a pass transistor to charge the periphery from an external voltage supply; and

    a comparator, coupled to the pass transistor, whose trip point is set by the output of the voltage reference generator and the charge supplied to the periphery, to control the pass transistor.

7.  A circuit as claimed in claim 4 for a memory device integrated onto a single semiconductor substrate, comprising:

    a memory array;

    support circuitry for reading information from the memory array and writing information to the memory array;

    a voltage generator to receive external voltage and generate internal reference voltage to power the memory array and support circuitry; and

    a circuit connected coupled to the memory array, to the external voltage, and to the internal reference voltage, supply to charge the memory array from the external voltage supply and to use the internal reference voltage to regulate the amount of supplied charge.

8.  A circuit as claimed in claim 7 and wherein the circuit includes:

    a transistor having one terminal connected to the external voltage, another terminal connected to ground, and having a gate, to drive the memory array; and

    a comparator having one comparison input connected to the internal voltage, the other comparison input coupled to the external voltage, and the output connected to the gate of the transistor, to compare the external voltage and the internal voltage and bias the gate of the transistor with the results of the comparison.

Fig. 1

Fig.2

LEADFRAME

TAPE

CHIP

*Fig. 4*

*Fig. 5*

VSS
DQ3
DQ2
CAS_
G_
A9
A8
A7
A6
A5
A4
VSS

VDD
DQ0
DQ1
W_
RAS_
A11
A10
A0
A1
A2
A3
DD

BOND
PADS

*Fig. 3*

Fig.6

Fig. 7

Fig. 8

6000 A

3500 A

AL-SI-CU

CVD W

500 A TI,W

7500 A OXIDE

5500 A CVD W　　500 A TI,W

4000 A OXIDE

2500 A SILICIDED POLY

3000 A OXIDE

7500 A OXIDE　2500 A　　POLY-2

1000 A NITRIDE　1800 A OXIDE　　500 A OVERLAP

1900 A POLY PLATE

2500 A　1300 A NITRIDE　　POLY-2

N+　150 A GATE OXIDE　N+　400 A OXIDE (1100 A OXIDE EQUIV.)　N+　150 A GATE OXIDE　N+

SCALES
1 MICRON

65 A OXIDE EQUIV.

1

2

Fig. 9

EP 0 469 589 A2

Fig. 10

EP 0 469 589 A2

*Fig.11*

Fig.12

Fig./3

*Fig.14*

EP 0 469 589 A2